# EUROPEAN PATENT APPLICATION

(11) **EP 4 294 128 A1**
(43) Date of publication of application: **20.12.2023**
(21) Application number: 23173428.6
(22) Date of filing: 15.05.2023
(51) Int. Cl.: H05B 45/33, H03K 4/02, H01S 5/042

(54) **EDGE RATE (RISE AND FALL TIME) CONTROLLED SEGMENTED LASER DRIVER**

(30) Priority: 15.06.2022 US 202217806987
(71) Applicant: II-VI Delaware, Inc., Wilmington, DE 19890 (US)
(72) Inventor: JONES, Theron, Wilmington, 19801 (US); DAVIS, Richard A., Wilmington, 19801 (US); CAREY, Brian, Wilmington, 19801 (US); YEUNG, Michael, Wilmington, 19801 (US); TROYER, Steve, Wilmington, 19801 (US); ASHBROOK, Jonathan, Wilmington, 19801 (US)
(74) Representative: Tegethoff, Sebastian

(57) **Abstract**

An optical driver circuit is described herein having a plurality of drive cells and delay segments between their control signals resulting in the control of the rising and falling edge rates for an optical device driven by the optical driver circuit.

## Description

### Field of the Disclosure

The present disclosure relates to optical driver circuits having edge rate control and methods of modifying edge rates in an optical driver circuit.

### Background of the Disclosure

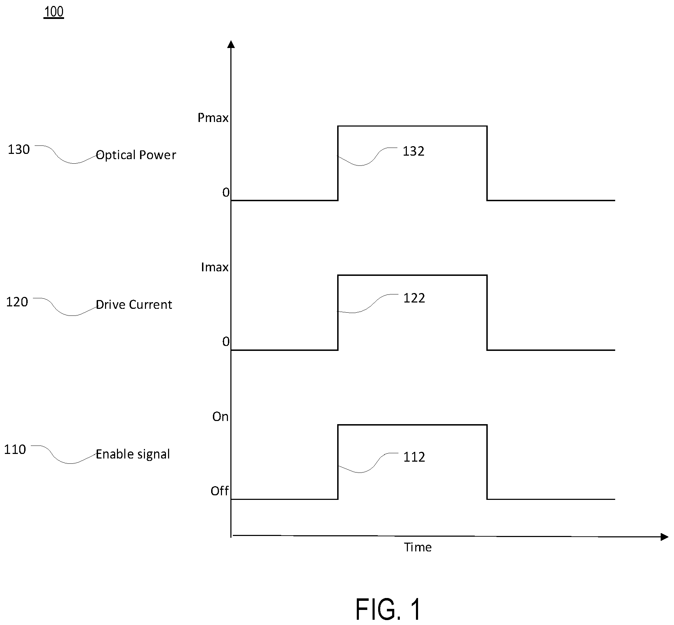

The optical output of light generating device can be controlled through the use of a driver switch, for example a transistor, that when enabled allows current to flow through the light generating device to emit optical power. Laser diodes are one example of semiconductor light generating devices. Shown in FIG. 1 is an example timing diagram 100 from the state of the art showing the optical power output 130 of a semiconductor laser based on a enable signal applied to a driver transistor, for example a field effect transistor (FET) in the current path of the laser.

When the enable signal goes to a logic high, current 120 flows through the driver transistor and the laser as represented by the increase in current at 122. Likewise, at 132, the laser optical power 130 will increase correspondingly. While there can be a delay between when the laser begins consuming electrical power and when the laser begins outputting optical power, that delay will be ignored for purposes of this disclosure.

### Summary of the Disclosure

Disclosed herein are example optical driver circuits having edge rate control. In one aspect of the disclosure, example optical driver circuits include a light generating device, a plurality of drive cells each in a current path of the light generating device, an enable control signal input logically interfaced to each drive cell, where the enable control signal input is adapted to receive an enable control signal, and at least one delay segment logically between at least one of the drive cells and the enable control signal input. In another aspect of the disclosure, each drive cell may include an enable transistor in the current path of a light generating device which is logically interfaced to an enable control signal input. In another aspect of the disclosure, a plurality of drive cells are configured in parallel with respect to each other, such that each drive cell is adapted to pass a fraction of a total current through the light generating device. In yet another aspect of the disclosure, the light generating device is a laser. In one example configuration, at least one of a plurality of drive cells includes a bias control transistor.

Disclosed herein are example optical driver circuits having edge rate control, in which the driver circuits include at least one delay segment and the delay segment is adapted to provide a logic delay of an enable control signal. In another aspect of the disclosure, an input of a logic low to a logic high transition at an enable control signal input of disclosed optical driver circuits results in a step-wise ascending function for a current through a light generating device. In another aspect of the disclosure, a time width of a step within a step-wise ascending function is equal to a time delay associated with at least one delay segment. In yet another aspect of the disclosure, an input of a logic high to a logic low transition at an enable control signal input of disclosed optical driver circuits results in a step-wise descending function for a current through a light generating device. In yet another aspect of the disclosure, at least one delay segment includes at least one of a shift register, a buffer, and/or a timer. In yet another aspect of the disclosure, at least one delay segment has an associated logic time delay and the time delay is configurable.

Disclosed herein are methods of modifying edge rates in an optical driver circuit, the optical driver circuit including a light generating device, a plurality of drive cells each in a current path of the light generating device, an enable control signal input logically interfaced to each drive cell. In one aspect of the disclosure, the methods may include providing an enable control signal to an enable control signal input, communicating the enable control signal to a first drive cell of the plurality of drive cells, delaying the enable control signal to create a delayed enable control signal, and communicating the delayed control signal to a second drive cell of the plurality of drive cells. In another aspect of the disclosure, delaying an enable control signal to create a delayed enable control signal is performed by at least one delay segment. In yet another aspect of the disclosure at least one delay segment includes at least one of a shift register, a buffer, and/or a timer. In another aspect of the disclosure, the methods can include passing a step-wise function for a current through the light generating device.

In one aspect of the disclosure, the enable control signal includes a logic low to a logic high transition and the step-wise function is an ascending step-wise function. In another aspect of the disclosure, the enable control signal includes a logic high to a logic low transition and the step-wise function is a descending step-wise function. In one aspect of the disclosure, the methods may include delaying the delayed control signal to create a further delayed enable control signal and communicating the further delayed control signal to a third drive cell of the plurality of drive cells. In yet another aspect of the disclosure the methods may include delaying the delayed control signal sequentially an integer number "n" times to create further n delayed enable control signals and communicating the further n delayed control signals to a plurality of drive cells, respectively

### Brief description of the drawings

The invention will be described based on figures. It will be understood that the embodiments and aspects of the invention described in the figures are only examples and do not limit the protective scope of the claims in any way. The invention is defined by the claims and their equivalents. It will be understood that features of one aspect or embodiment of the invention can be combined with a feature of a different aspect or aspects of other embodiments of the invention, in which:
FIG. 1 (state of the art) shows a schematic digital timing diagram of a prior art optical driver circuit;
FIG.2 shows an optical driver circuit schematic in accordance with disclosed embodiments;
FIG. 3 shows a schematic digital timing diagram of the optical driver circuit of FIG. 2 in accordance with disclosed embodiments.

Throughout the drawings, like elements are designated by like reference numerals and other characters. The drawings show non-limiting examples for purposes of illustration and explanation of the present disclosure, and are not drawn to scale.

### Detailed Description

The technical problem is solved by the independent claims. The dependent claims cover further specific embodiments of the invention.

While prior art driver designs have utilized an "as fast as possible" design scheme such that the drive current and laser optical power react quickly and fully to changes in an enable drive signal, it may be desirable to have control, for example slowing down, the edge rate of the of the optical drive current / optical power. For example, a sudden jump in current can create large electromagnetic interference (EMI); it may be desirable to control the magnitude of current-generated EMI. Further, optical receivers may desire differing pulse shapes, for example, for various digital signal processing computations, as such a receiver may specify different pulse shapes for receiver input. For purposes of this disclosure, edge rate refers to the rate at which the drive current through the respective optical device, e.g., an increase or decrease laser current, changes in response to a corresponding enable or modulation signal in the driver, which could also be expressed as a slope, an average slope, or derivative of the drive current.

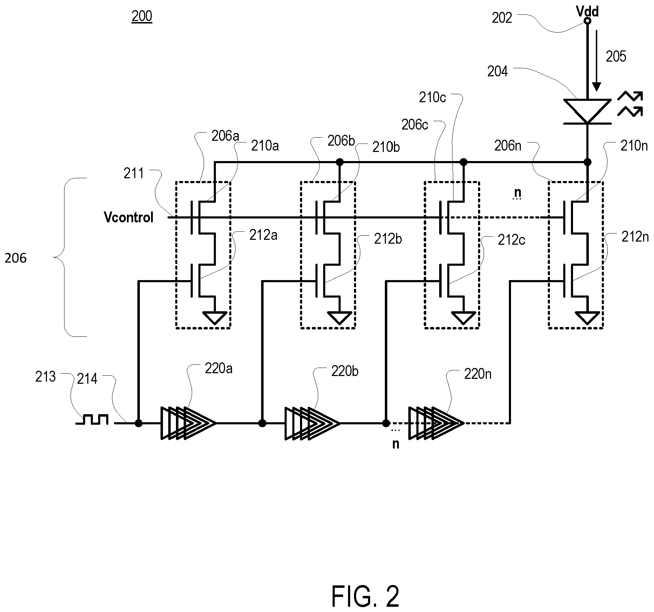

Shown in FIG.2 is an example optical driver circuit 200 configured to control such an edge rate through an optical device. Example optical driver circuit 200 includes a semiconductor laser 204, however other optical devices, for example light emitting diodes (LED) may also be used. The laser 204 is supplied power from a supply power bus 202 also labeled Vdd for providing a supply voltage. As current 205 flows through laser 204 the laser 204 will output optical power. The current 205 through the laser 204 is controlled via a plurality of laser drive cells 206 in the current path of the laser 204. The plurality of laser drive cells 206 are shown as 206a, 206b, 206c ... 206n to represent there can be any integer "n" of drive cells 206, which will be collectively referred to as drive cells 206. As shown, the drive cells 206 each pass a portion of the total laser current 205 and are arranged in parallel. While the remainder of this disclosure will discuss the drive cells 206 as having similar components, which would result in each drive cell passing approximately equal amounts of current, the drive cells 206 need not be similarly sized and thus, according to different configurations, certain drive cells 206 can be configured to pass more current than other drive cells.

Each drive cell 206 may include a driver enable transistor 212a, 212b, 212c ... 212n, respectively (collectively 212 and using the same numbering scheme for integer n drive cells 206) in the current path of the laser 204. The driver enable transistors 212 each function as an "on"/ "off" enable transistor for each drive cell 206 or for time cycling or modulating the laser using an enable control signal 213 at an enable input 214.

Optionally, each drive cell 206 may also, respectively, include bias control transistor 210a, 210b, 210c ... 210n (collectively 210). The bias control transistors may collectively bias the laser 205 using bias control signal 211 to a desired current level for proper modulation response. An example for deriving the bias control signal using a proxy drive cell is disclosed in US application number 17/804,792 title "Current Load-Controlled Laser Driver" and filed on May 31, 2022, which is hereby incorporated by reference herein in its entirety. In such a configuration, the driver enable transistors 212 may be adapted to digitally time cycle the laser 204 via the driver enable gate control signal 213, while the bias control transistors 210, via driver bias gate control signal 211, controls the bias current of the laser 205.

While FIG. 2 shows example uses of n channel metal-oxide-semiconductor field-effect transistors (MOSFETs) for negative side control of the laser 204 for demonstration purposes, it should be understood that other types of transistors or field effect transistors (FETs) may also be used depending on the configuration, e.g., positive or negative side control. Similarly, the disclosure is not limited to n or p channel transistors where they are depicted.

In order to slow down the edge rates of the laser 205, as compared to near instantaneous on and off, the driver circuit 200 has a series of delay segments 220 (220a, 220b ...220n) logically, respectively, between the enable control signal 213 and one or more of the drive cell 206 enable transistors 212. Each delay segment will establish a pulse delay ΔTa, ΔTb . . .ΔTn, respectively. ΔTa, ΔTb . . .ΔTn can be equivalent time delays or different time delays depending on the configuration. Delay segments 220 can be implemented, for example, through the use of shift registers, CMOS buffer, timers, or other known forms in the art for establishing a pulse delay, e.g. by current starving or restricting each buffer. Further, each individual delay segment 220 can include one or more discrete implementations. For example, a cascade of from 0 to N logic buffers may also be used for each delay segment 220. Further, the delay segments 220 can be programmable, for example a programmable cascade of logic buffers or any other programable delay circuit. In an alternative configuration, the delay segments 220 could be based on an external timer or clocks, for example using flip-flop circuits, counters, or other implementations using multiples of a set or configurable time base. Other methods of establishing a delay pulse may also be used. See for example US 17/443,110 entitled Pre-Charge Modulation of A Laser Array For 3d Imaging Application and filed July 21, 2021 describes several programable delay configurations utilizing a multiplexer and is hereby incorporated by reference herein in its entirely.

As shown in FIG. 2, the delay segments 220 may be sequentially summed. In such a configuration, the total time delay experienced by enable transistor 212b is equal to the time delay ΔTa of delay segment 220a, while the total time delay experienced by enable transistor 212c is equal to the time delay ΔTa of delay segment 220a added to the time delay ΔTb of delay segment 220b. However, alternatively, the time delay segments can logically connected in parallel to driver enable gate control signal 213 and configured individually.

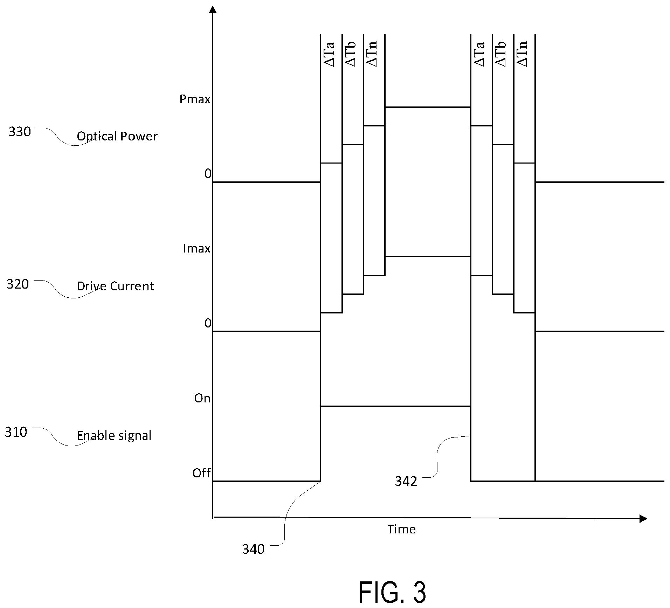

Shown in FIG. 3 is an example timing diagram for the optical driver circuit 200 of FIG. 2 in which the integer n number of drive cells is four and the integer number of delay segments 220 is three. The drive current 320 (e.g., current 205 of FIG. 2) is shown in response to an example enable signal 310 input at 214 (FIG. 2). At time 340 when the enable signal transitions from low (off) to high (on), instead of the drive current 320 (and optical power going to maximum immediately, like that shown in FIG. 1, the current through laser 204 only increases fractionally at time 340 equivalent to the current passing through drive cell 206a (FIG. 2) which is enabled without delay. After an additional time period of ΔTa, the high enable control signal 213(FIG. 2) / 310, which is now a delayed enable control signal by the delay ΔTa, is logically communicated to drive cell 206b, which triggers high enable transistor 212b, which then passes an additional fractional amount of current through laser 204 and drive cell 206b. After an additional time period of ΔTb, after which the high enable control signal 213(FIG. 2) / 310 (i.e., the delayed enable control signal) is now a further delayed control signal by ΔTb, is logically communicated to drive cell 206c, which triggers high enable transistor 212c, which then passes an additional fractional amount of current through laser 204 and drive cell 206c. Lastly after an additional time period of ΔTn, the high enable control signal 213(FIG. 2) / 310, which is now even further delayed by ΔTn, is logically communicated to drive cell 206n, which triggers high enable transistor 212n, which then passes an additional fractional amount of current through laser 204 and drive cell 206n.

The same sequence occurs at time 342 when the enable signal 310 changes from high to low, only the delay now occurs in the edge rate fall of drive current 320 and optical power 330. Accordingly, the drive pulse, i.e., enable signal 213 of FIG. 2 or 310 of FIG 3 is effectively staggered in time resulting in a step-wise function for the laser 204 current 205 (and optical power) and the laser edge rates, both rising and falling, are reduced. While the example shown in FIG. 3 shows a stepwise input signal (enable signal 310), in an alternative, other waveforms may be used, such as curves, functions, or non-linear inputs. However, the stepwise example is shown for simplicity.

In an alternative configuration, each of the delay segments 220 are configured or programmed to have zero delay in which case all of the drive cells 206 can be turned on simultaneously.

In addition to the advantages discussed above with respect to decreasing the edge rate rise and fall rates, reducing edge rates may also aid in reducing transients and disturbances in power supply and grounds, which could potentially negatively impact other connecting circuits.

## Claims

1. An optical driver circuit comprising:
a light generating device;
- a plurality of drive cells each in a current path of the light generating device;
- an enable control signal input logically interfaced to each drive cell, wherein the enable control signal input is adapted to receive an enable control signal; and
- at least one delay segment logically between at least one of the drive cells and the enable control signal input.

2. The optical driver circuit of claim 1, wherein each drive cell includes an enable transistor in the current path of the light generating device and is logically interfaced to the enable control signal input.

3. The optical driver circuit of claim 1, wherein the plurality of drive cells are configured in parallel with respect to each other, such that each drive cell is adapted to pass a fraction of a total current through the light generating device.

4. The optical driver circuit of claim 1, wherein the light generating device is a laser.

5. The optical driver circuit of claim 1, wherein at least one of the plurality of drive cells further comprises a bias control transistor.

6. The optical driver circuit of claim 1, wherein the at least one delay segment is adapted to provide a logic delay of the enable control signal.

7. The optical driver circuit of claim 1, wherein an input of a logic low to a logic high transition at the enable control signal input results in a step-wise ascending function for a current through the light generating device.

8. The optical driver circuit of claim 6, wherein the time width of a step within the step-wise ascending function is equal to a time delay associated with the at least one delay segment, respectively.

9. The optical driver circuit of claim 1, wherein an input of a logic high to a logic low transition at the enable control signal input results in a step-wise descending function for a current through the light generating device.

10. The optical driver circuit of claim 1, wherein the at least one delay segment includes at least one of a shift register, a buffer, and/or a timer.

11. The optical driver circuit of claim 1, wherein the at least one delay segment has an associated logic time delay.

12. The optical driver circuit of claim 1, wherein the time delay is configurable.

13. A method of modifying edge rates in an optical driver circuit, the optical driver circuit including a light generating device, a plurality of drive cells each in a current path of the light generating device, an enable control signal input logically interfaced to each drive cells, the method comprising:
- providing an enable control signal to the enable control signal input;
- communicating the enable control signal to a first drive cell of the plurality of drive cells;
- delaying the enable control signal to create a delayed enable control signal; and
- communicating the delayed control signal to a second drive cell of the plurality of drive cells.

14. The method of claim 12, wherein delaying the enable control signal to create a delayed enable control signal is performed by at least one delay segment.

15. The optical driver circuit of claim 14, wherein the at least one delay segment includes at least one of a shift register, a buffer, and/or a timer.

16. The method of claim 12, further comprising passing a step-wise function for a current through the light generating device.

17. The optical driver circuit of claim 15, wherein the enable control signal includes a logic low to a logic high transition and the step-wise function is an ascending step-wise function.

18. The optical driver circuit of claim 15, wherein the enable control signal includes a logic high to a logic low transition and the step-wise function is a descending step-wise function.

19. The method of claim 12, further comprising delaying the delayed control signal to create a further delayed enable control signal and communicating the further delayed control signal to a third drive cell of the plurality of drive cells.

20. The method of claim 12, further comprising delaying the delayed control signal sequentially an integer number "n" times to create a further n delayed enable control signals and communicating the further n delayed control signals to a plurality of drive cells, respectively.
